# FASCICULE DE BREVET EUROPEEN

(11) **EP 2 719 012 B1**
(45) Date de publication et mention de la délivrance du brevet: **15.04.2015**
(21) Numéro de dépôt: 12721565.5
(22) Date de dépôt: 22.05.2012
(51) Int. Cl.: H01M 10/48, H01M 8/04, G01R 31/36, G01R 19/165

(54) **DISPOSITIF DE SURVEILLANCE DE LA TENSION DELIVREE PAR LES CELLULES D'UN GENERATEUR ELECTROCHIMIQUE**
VORRICHTUNG ZUR ÜBERWACHUNG DES SPANNUNGSAUSGANGS DER ZELLEN EINES ELEKTROCHEMISCHEN GENERATORS
DEVICE FOR MONITORING THE VOLTAGE OUTPUT BY THE CELLS OF AN ELECTROCHEMICAL GENERATOR

(30) Priorité: 10.06.2011 FR 1155089
(43) Date de publication de la demande: 16.04.2014
(73) Titulaire: Commissariat à l'Énergie Atomique et aux Énergies Alternatives, 75015 Paris (FR)
(72) Inventeur: BUZON, Didier, F-38000 Grenoble (FR); CHATROUX, Daniel, F-38470 Teche (FR)
(74) Mandataire: Desvignes, Agnès
(86) Numéro de dépôt international: PCT/EP2012/059468
(87) Numéro de publication internationale: WO 2012/168066

(56) Documents cités:
- FR-A1- 2 427 817
- JP-A- 6 233 474
- JP-A- 2004 157 077

## Description

### DOMAINE TECHNIQUE

L'invention concerne une surveillance de la tension délivrée par les cellules élémentaires de générateurs électrochimiques, permettant de contrôler leur état de fonctionnement.

### ETAT DE L'ART

Les générateurs électrochimiques sont habituellement constitués d'un empilement de multiples cellules en série. En effet, une cellule élémentaire ne permet pas de fournir une tension de sortie d'un niveau suffisant pour être exploitable comme source d'énergie dans un appareil électrique industriel ou grand public : une cellule de pile à combustible est susceptible de fournir une tension comprise entre 0.4 volt et 1.2 volts, en fonction de la nature de la pile, et notamment en fonction du carburant et du comburant utilisés, et du courant électrique délivré, ce qui dépend principalement de la charge ; une cellule de batterie, est susceptible de fournir une tension comprise entre 1.2 volts à 3.8 volts, suivant l'état de charge de la cellule, de la température, et du courant électrique délivré.

L'empilement de cellules en série permet par effet additif, d'obtenir une tension de sortie exploitable pour une utilisation de ces générateurs comme source d'énergie dans des systèmes électriques, pour des applications variées du domaine grand public ou industrielles. Cela peut aller du système d'alimentation électrique pour la recharge de dispositifs portables (téléphone, ordinateur), au système d'alimentation électrique pour des systèmes embarqués de puissance, par exemple pour la traction électrique de véhicule. On peut encore citer comme application industrielle de ces générateurs, les stations de stockage d'énergie (électrique ou gaz).

Pour toutes ces applications, on doit pouvoir garantir les performances annoncées du générateur électrochimique (caractéristique courant/tension) sur toute la durée de vie du système concerné.

Aussi est-il nécessaire en pratique de surveiller la tension délivrée par chaque cellule d'un générateur électrochimique. En effet, la dégradation des performances d'une cellule de l'empilement affecte directement les performances du générateur, et peut également dégrader de manière réversible ou irréversible ou détériorer prématurément toutes ou une partie des cellules.

Il est ainsi habituel de prévoir des moyens de surveillance qui permettent de mesurer l'évolution avec le temps des tensions aux bornes de chaque cellule. Ces mesures permettent, par comparaison avec les performances nominales, de détecter des variations éventuelles, et d'obtenir ainsi une indication sur l'état de santé de chaque cellule du générateur, et sur son vieillissement.

Il y a les variations liées aux conditions d'utilisation, tel que le courant électrique délivré ou la température, et les variations liées au vieillissement naturel des cellules : on trouve alors une évolution comparable pour chacune des cellules. Mais il y a aussi des variations de tension dues à des défauts de certaines cellules qui, si aucune action n'est prise, peuvent entraîner un vieillissement prématuré d'une ou des cellules, voire une détérioration totale. Par exemple lorsque l'état de charge d'une cellule de batterie est différente des autres cellules, cela peut entraîner une surcharge ou une décharge profonde de cette cellule, voire à terme des autres cellules, et leur vieillissement prématuré. Dans un autre exemple, lorsqu'une cellule de pile à combustible subit une perturbation momentanée, par exemple la mauvaise évacuation de l'eau générée par la réaction électrochimique, ou une quantité insuffisante de carburant ou de comburant dans les sites catalyseurs, la tension de la cellule peut baisser transitoirement. Si elle baisse en dessous d'une tension seuil caractéristique, la cellule peut connaître des échauffements qui peuvent la détériorer de manière irréversible.

Ainsi l'ensemble des informations obtenues par le relevé et l'analyse de l'évolution avec le temps de la tension aux bornes de chaque cellule rend compte de son fonctionnement normal, ou pas. Ces informations permettent plus généralement de vérifier les performances du générateur électrochimique.

Suivre et analyser l'évolution des tensions de sortie des cellules suppose des moyens de mesure de la tension aux bornes de chaque cellule, et des moyens de mise en forme et de traitement de signal permettant l'analyse des mesures, pour obtenir des informations sur leur bon fonctionnement.

Or la compacité de ces générateurs électrochimiques est souvent telle que la densité de la connectique y est très importante, ce qui rend difficile voire critique, la mesure des tensions aux bornes des cellules.

On trouve dans l'art antérieur diverses solutions technologiques pour réaliser cette surveillance des tensions délivrées par les multiples cellules d'un générateur électrochimique. On peut classer ces solutions en deux familles principales :
- les solutions externes, qui utilisent une carte de mesure que l'on vient connecter via un connecteur filaire robuste conçu à cet effet sur le générateur. La carte de mesure intègre le ou les capteurs, selon qu'elle effectue toutes les mesures en parallèle, ou les unes à la suite des autres, et des moyens de transmission vers des outils d'analyse comprenant typiquement des moyens de traitement de signal. Dans ces solutions, une difficulté technologique majeure liée à la compacité des générateurs réside dans la connectique. Le connecteur filaire doit ainsi être spécialement conçu pour assurer des contacts fiables et robustes avec la carte de mesure. En pratique, la conception de ces connecteurs est très dépendante de la conception mécanique du générateur électrochimique considéré. Par ailleurs, il peut s'avérer difficile de garantir dans le temps la qualité des contacts électriques, dans les conditions normales d'utilisation d'un appareil grand public ou industriel et sur toute la durée de vie de l'appareil. Ces solutions de surveillance sont tout particulièrement difficiles à mettre en oeuvre dans les générateurs destinés à des applications de puissance qui sont constituées d'un grand nombre de cellules dans un empilement très compact, dans les piles à combustible notamment : le risque de court-circuit entre deux fils de mesure et le risque de démontage ou de cassure d'un fil de mesure y sont particulièrement élevés.
- les solutions utilisant un circuit intégré au générateur, qui comporte des moyens de mesure de tension aux bornes des cellules, associés à des moyens de transmission sans contact, par ondes radiofréquences, pour délivrer l'information mesurée à des moyens d'analyse externes. Ces solutions intégrées ont comme inconvénient majeur d'être généralement plus coûteuses que les solutions filaires.

Par ailleurs ces différentes solutions requièrent généralement une source de tension régulée, qui peut avoir pour effet de décharger de manière non homogène les cellules du générateur. En outre, dans le cas de générateurs électrochimiques utilisés dans des systèmes embarqués de puissance, les normes électriques en vigueur imposent une bonne tenue diélectrique d'isolement électrique entre le circuit de puissance et le contrôle commande.

FR 2 427 817 A1 divulgue un dispositif pour la surveillance de la force électromotrice d'une pile électrique qui comprend un circuit de résonance, formé par une diode varicap et une inductance, le circuit étant couplé à un oscillateur.

JP 6 233474 A décrit une méthode de détection de la tension d'une batterie en utilisant une diode varicap D1 qui forme un circuit de résonance avec un dispositif à ondes acoustiques de surface.

JP 2004 157077 A divulgue d'utiliser une diode varicap 2 en combinaison avec un générateur 3 de fréquence variable pour déterminer la tension d'une cellule individuelle d'un empilement de cellules électriquement connectées en séries.

Une isolation galvanique adaptée doit alors être prévue, ce qui peut être très contraignant pour certaines techniques de mesure de tension.

### RESUME DE L'INVENTION

Un objectif de l'invention est de proposer une solution alternative de surveillance de l'état des cellules d'un générateur électrochimique, qui soit à la fois peu coûteuse, simple de mise en oeuvre, même dans les systèmes embarqués de puissance, et fiable dans le temps.

Contrairement aux solutions technologiques de l'art antérieur qui reposent toutes sur la mesure directe de la tension aux bornes des cellules, on propose de réaliser une mesure indirecte de cette tension.

L'idée à la base de l'invention repose sur l'utilisation d'un circuit résonant comprenant un composant passif réactif polarisé par la tension délivrée par une cellule, et dont l'impédance varie en fonction de la tension continue à ses bornes. Une variation de la tension délivrée par une cellule se traduit alors par une variation de la fréquence de résonance du circuit de résonance associé. Cette transposition dans le domaine fréquentiel permet une simplification de la connectique et réduit considérablement tous les risques de dysfonctionnement associés. Elle simplifie aussi la réalisation de l'isolation galvanique, pour les systèmes embarqués de puissance. Autre avantage, la mesure réalisée est passive, car elle nécessite très peu de courant, ce qui participe de la fiabilité, de la compacité et de la robustesse du système de surveillance proposé.

Plus précisément, on propose selon l'invention un générateur électrochimique composé d'au moins un empilement de multiples cellules électriquement en série et pourvu de moyens de contrôle de la tension aux bornes de ces cellules, caractérisé en ce que les moyens de contrôle comportent :
- pour chaque cellule à contrôler,
- un premier composant passif réactif dont l'impédance varie en fonction de la tension continue à ses bornes, ce composant étant alimenté par la tension d'au moins une cellule à contrôler, et
- au moins un deuxième composant passif réactif formant avec le premier composant passif réactif un circuit résonant série ou parallèle ayant une fréquence de résonance nominale prédéterminée pour une tension nominale fournie par la cellule,
- un générateur de signal à fréquence variable alimentant l'ensemble des circuits résonants,
- un moyen de détection de la position de pics de résonance de l'ensemble ainsi alimenté, ce moyen fournissant une indication d'un écart entre une fréquence de résonance correspondant à un pic détecté et une fréquence de résonance nominale.

Dans un mode de réalisation, les circuits résonants sont connectés en série, et le premier composant passif réactif d'un circuit résonant est polarisé par la tension délivrée par une cellule.

Le premier composant réactif est avantageusement une diode varicap et le deuxième composant passif réactif est soit une inductance, soit un circuit résonant tel qu'un quartz par exemple.

Dans une première configuration d'utilisation de l'invention, les circuits résonants correspondant à différentes cellules ont des fréquences de résonance nominales différentes.

Le moyen de détection détecte alors différents pics de résonance, correspondant aux différentes cellules. A partir de la détection des positions des pics de résonance sur un signal relevé aux bornes de l'ensemble des circuits résonants, on peut ainsi obtenir des informations sur l'état de chacune des cellules de l'empilement.

Selon une mise en oeuvre de l'invention, les circuits résonants sont alimentés par le générateur par l'intermédiaire d'une connexion filaire.

Selon une autre mise en oeuvre de l'invention, les circuits résonants sont alimentés par le générateur par l'intermédiaire d'un transformateur d'isolement.

Dans une variante, alors que l'excitation des circuits résonants se fait de manière filaire, la mesure/détection du signal de tension utilise des moyens radiofréquences.

Dans une autre variante, l'excitation des circuits résonants et la mesure/détection du signal de tension utilisent des moyens radiofréquences.

D'autres caractéristiques et avantages de l'invention apparaîtront à la lecture de la description détaillée qui suit et qui est faite en référence aux dessins annexés dans lesquels :
- la figure 1 représente un circuit de contrôle de la tension des cellules d'un empilement de cellules d'un générateur électrochimique, suivant un premier mode de réalisation dans lequel les circuits résonants sont du type circuit résonant parallèle et sont placés en série ;
- la figure 2 représente une variante de ce circuit de contrôle ;
- la figure 3 représente l'allure de la courbe |Z|=g(f_{g}) de variation de l'impédance aux bornes de l'ensemble des circuits résonants du circuit de contrôle de la figure 1 ou 2, avec la fréquence f_{g} du signal d'excitation du générateur, pour des circuits résonants centrés sur des fréquences de résonance nominales différentes, et pour des cellules délivrant toute une tension nominale ;
- la figure 4 représente une évolution de cette courbe |Z|= g(f_{g}), illustrant le cas d'une dérive homogène des cellules de l'empilement ;
- la figure 5 représente l'allure d'une courbe |Z|= g(f_{g}), illustrant le cas d'une cellule défectueuse dans l'empilement ;
- les figures 6 et 7 représentent des courbes |Z|= g(f_{g}) obtenues dans un exemple d'une implémentation du circuit des figures 1 ou 2 dans laquelle tous les circuits résonants sont centrés sur la même fréquence de résonance nominale, la figure 6 illustrant deux courbes, l'une en trait plein correspondant à un fonctionnement nominal des cellules et l'autre en pointillés, montrant une variation homogène de toute les cellules, et la figure 7 mettant en évidence un défaut attribuable à au moins une cellule de l'empilement ;
- la figure 8 illustre les trois courbes de tension, courant et impédance relevées aux bornes de l'empilement en fonction de la fréquence, obtenues par simulation pour un empilement de 8 cellules électrochimiques, et dans un exemple d'une implémentation avec des circuits résonants centrés sur des fréquences de résonance nominale différentes ;
- les figures 9 à 12 illustrent les courbes d'impédance de la figure 8, obtenues par simulation, reflétant l'évolution dans le temps des 8 cellules de l'empilement ;
- la figure 13 représente un circuit de contrôle de l'invention, dans une implémentation incorporant une isolation galvanique via l'utilisation d'un transformateur électromagnétique ;
- la figure 14 représente un circuit de contrôle de l'invention, dans lequel l'excitation et la détection sont transmises par ondes électromagnétiques (radiofréquences) dans un exemple de réalisation où l'élément inductif du circuit résonant est également l'antenne magnétique de transmission ;
- la figure 15 représente un circuit de contrôle de l'invention, utilisant une transmission radiofréquence de signal, utilisant des antennes électriques ;
- la figure 16 représente une variante de réalisation du circuit de la figure 15 ;
- la figure 17 représente un circuit de contrôle selon un autre mode de réalisation des circuits résonants, avec une structure imbriquée ;
- la figure 18 représente une variante série des circuits résonants de la figure 1 ; et
- la figure 19 illustre l'allure d'une courbe |Z|=g(f_{g}) correspondante.

### DESCRIPTION DETAILLEE DE L'INVENTION

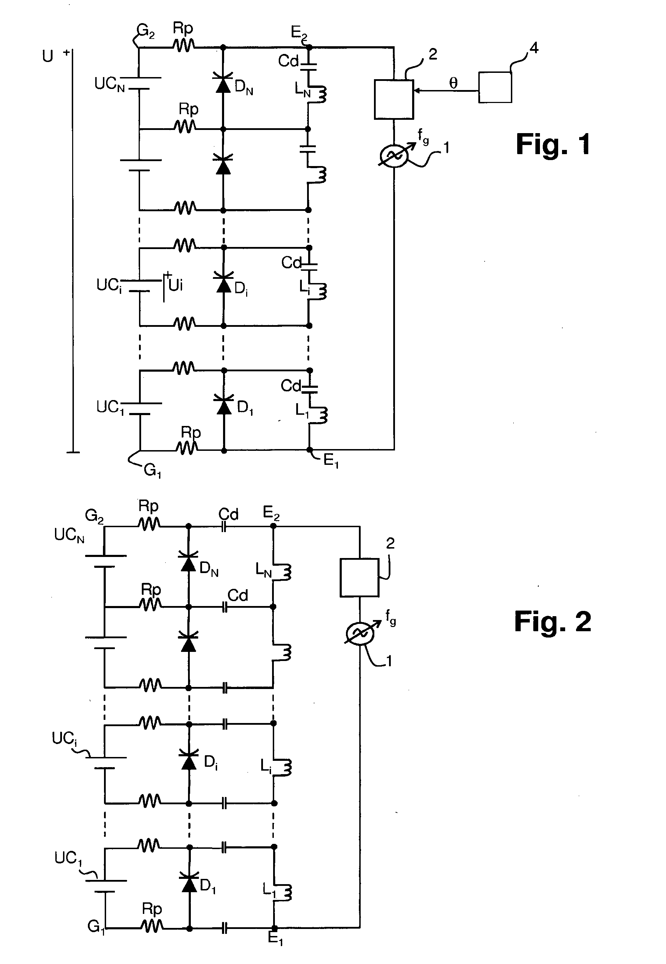

Un premier mode de réalisation d'un circuit de contrôle selon l'invention est illustré sur la figure 1, appliqué à un empilement de N cellules UCᵢ d'un générateur électrochimique. Chaque cellule UCᵢ délivre à ses bornes une tension continue élémentaire Ui. Aux bornes G₁, G₂ de l'empilement, on obtient une tension U égale à la somme des N tensions continues élémentaires Ui.

Le circuit de contrôle comprend un circuit résonant par cellule UCᵢ. Le circuit résonant comprend un premier composant passif réactif Dᵢ et un deuxième composant passif réactif Lᵢ, connecté aux bornes de chaque cellule UCᵢ. L'ensemble des circuits résonants sont placés en série. Le premier composant passif réactif est de préférence une diode varicap et le deuxième composant passif réactif, une inductance. Ils sont connectés chacun en parallèle sur la cellule UCᵢ, comme illustré, formant un circuit résonant de type LC parallèle, avec la capacité Cᵢ de la diode varicap et l'inductance Lᵢ. La cellule UCᵢ assurant la fonction de polarisation en tension de la diode varicap, la valeur de la capacité Cᵢ de la diode reflète le niveau de la tension Ui délivrée par la cellule UCᵢ. Ainsi, la mesure de la fréquence de résonance du circuit résonant (Lᵢ,Dᵢ) est une mesure indirecte de la tension délivrée par la cellule UCᵢ.

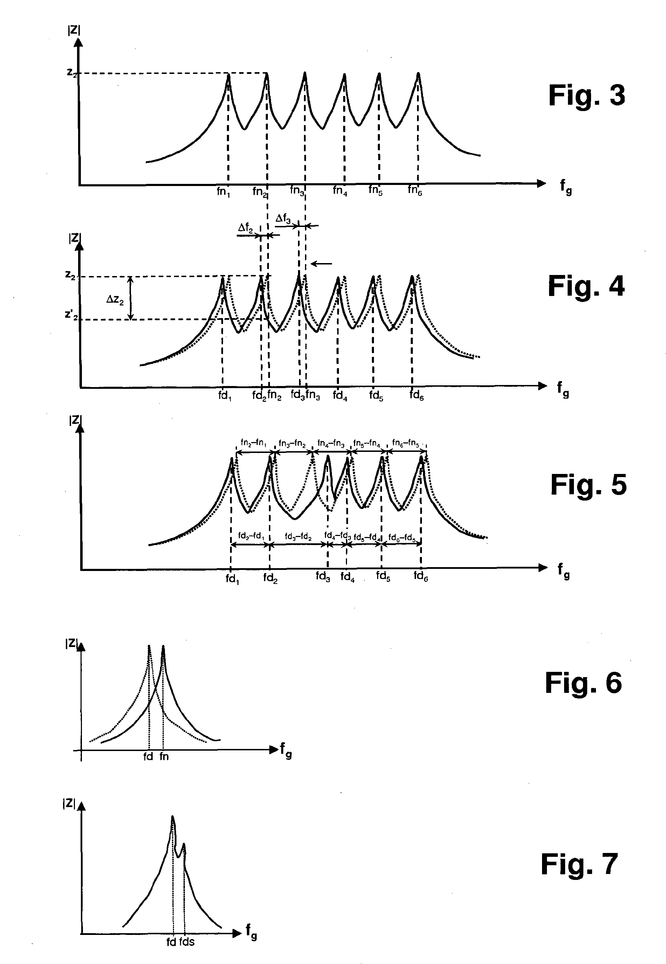

Cette mesure indirecte est obtenue en utilisant des moyens d'excitation/détection des circuits résonants comprenant un générateur 1 d'un signal de fréquence f_{g} variable pour alimenter l'ensemble des circuits résonants et un moyen 2 de détection de la position de pics de résonance : lorsque la fréquence f_{g} du signal délivré par le générateur correspond à la fréquence de résonance fdᵢ d'un circuit résonant (Dᵢ, Lᵢ), la courbe |Z|=g(f_{g}) (figure 3) laissera apparaître un pic de résonance correspondant à la mise en oscillation du circuit résonant concerné. Ce circuit d'excitation/détection est représenté de manière très symbolique sur les figures par un rectangle représentant un circuit de détection 2 en série avec un cercle représentant le générateur d'un signal d'excitation de fréquence variable, l'ensemble étant placé en parallèle aux bornes E₁ et E₂ de l'ensemble des circuits résonants.

De préférence, et comme illustré, on prévoit pour chacun des circuits résonants au moins une capacité de découplage Cd placée en série avec l'inductance Lᵢ, cet ensemble série lui-même placé en parallèle sur la diode varicap Di. Ces capacités de découplage permettent d'isoler les inductances Lᵢ, de la tension continue délivrée par les cellules.

Dans l'exemple illustré sur la figure 1, on a ainsi N capacités de découplage Cd, une par circuit résonant.

Dans une variante illustrée sur la figure 2, les circuits résonants partagent deux à deux une capacité de découplage Cd. Ce montage permet avec N+1 capacités de découplage Cd, de placer deux capacités de découplage Cd par circuit résonant, connectées de chaque côté de la cellule UCᵢ correspondante.

Chaque diode varicap peut être polarisée directement par la tension délivrée par la cellule UCᵢ associée, ou, comme illustré sur les figures 1 et 2, par l'intermédiaire de résistances Rp. Dans l'exemple, une résistance Rp est placée en série entre chaque borne de la cellule UCᵢ et la diode varicap associée. Pour N cellules, ceci est réalisé avec N+1 résistances Rp, les cellules partageant deux à deux une même résistance de découplage.

Cette résistance Rp permet le découplage du circuit de polarisation de la diode varicap Dᵢ, comprenant la cellule UCᵢ et la diode varicap Dᵢ, du circuit résonant formé par la diode varicap Dᵢ et l'inductance Lᵢ, dans le régime petits signaux alternatifs. Cette résistance a en pratique une valeur élevée, de l'ordre de 10⁶ ohms, ce qui ne perturbe pas le circuit de polarisation, le courant de polarisation inverse de la diode étant quasi nul.

Toute variation de la tension élémentaire Ucᵢ délivrée aux bornes d'une cellule, va se traduire par une variation de la capacité de la diode varicap, et donc par une variation de la fréquence de résonance du circuit résonant (Dᵢ, Lᵢ) associé à la cellule.

C'est la détection de cette variation qui est exploitée dans l'invention pour recueillir des informations sur l'état des cellules.

Le principe de la détection est illustré sur les figures 3 à 5. On a pris l'exemple d'un empilement de N=6 cellules, avec une implémentation de l'invention, dans laquelle les N=6 circuits résonants associés aux cellules ont des fréquences de résonance nominale différentes, notées fn₁ à fn₆. Typiquement, les caractéristiques des diodes varicap et les inductances de chacun des circuits résonants sont choisies pour obtenir les différentes fréquences de résonance nominale voulues pour une tension nominale aux bornes de chacune des cellules, avec un coefficient de qualité le meilleur possible ce qui rend favorable la détection précise de la position des pics de résonance.

Le circuit de détection 2 permet de déterminer le niveau du module |Z| de l'impédance (ou le niveau de l'impédance, pour simplifier), aux bornes E₁ et E₂ de l'ensemble des N circuits résonants. Cette détermination d'impédance se fait de manière classique, par une mesure de tension et/ou de courant aux bornes E₁ et E₂, et selon les caractéristiques électriques du signal d'excitation émis par le générateur 1 utilisé, sans qu'il soit utile de la détailler.

Les fréquences de résonance nominales fn₁ à fn₆ étant décalées, la courbe de variation de cette impédance avec la fréquence f_{g} du générateur 1, comporte N pics de résonance décalés. S'agissant de circuits résonants de type LC parallèles, chaque pic de résonance correspond à un maxima d'impédance obtenu à une fréquence f_{g} égale à la fréquence nominale de résonance correspondante. La courbe |Z|=g(f_{g}) aux bornes de l'ensemble des circuits résonants a ainsi l'allure représentée sur la figure 3.

Dans le cas d'un vieillissement normal et homogène des cellules de l'empilement, lorsque le courant délivré par le générateur électrochimique évolue, ou dans le cas d'une variation de la température moyenne du générateur électrochimique, les tensions délivrées par les cellules varient au cours du temps sensiblement de la même manière : les fréquences de résonance des circuits résonants vont alors évoluer sensiblement de la même manière, par une translation sensiblement homogène, c'est-à-dire sans déformation sensible de la courbe. C'est ce qui est illustré sur la figure 4 : la courbe nominale, mesurée à un instant t₀, est en pointillé ; et la nouvelle courbe, mesurée à un instant t est en trait plein.

Dans le cas d'une baisse de tension sur une seule des cellules, seule la fréquence de résonance du circuit de résonance associé va bouger : sur la courbe |Z|=g(f), le pic de résonance correspondant va se rapprocher d'un pic de résonance adjacent, modifiant l'allure générale de la courbe comme illustré sur la figure 5.

Ainsi, le relevé des courbes |Z|=g(f) au cours du temps, permet de surveiller l'état des cellules de l'empilement.

En pratique, on peut exploiter ces courbes de différentes manières pour obtenir des informations sur l'état des cellules.

Il est utile de signaler que la position des pics de résonance détectés permet de remonter à la mesure absolue de la tension délivrée aux bornes de chaque cellule. Chaque pic de résonance détecté correspond à un circuit résonant déterminé donc à une cellule déterminée. La position d'un pic de résonance donne ainsi la fréquence de résonance fdᵢ du circuit de résonance correspondant. Les valeurs des inductances des circuits résonants étant connues, cette fréquence de résonance fdᵢ permet de remonter par calcul (fdᵢ =1/2π(Lᵢ.cᵢ)^{½} à la valeur Cᵢ de capacité de la diode varicap Dᵢ du circuit de résonance et par suite à la tension Ui délivrée par la cellule, en exploitant la courbe caractéristique capacité-tension de la diode varicap.

Mais l'invention permet d'exploiter directement les mesures de fréquence de résonance, pour obtenir des informations sur l'état des cellules, sans qu'il soit nécessaire de remonter à la tension délivrée par chaque cellule.

Dans une première mise en oeuvre, on utilise l'information absolue donnée par la position de chaque pic de résonance détecté, pour obtenir une indication sur l'état d'une cellule correspondante. Elle consiste ainsi à déterminer pour chaque pic de résonance, l'écart avec sa position nominale.

Ceci peut se faire en mesurant pour chaque pic de résonance détecté, l'écart entre la fréquence de résonance correspondante et la fréquence de résonance nominale. Δf₂ et Δf₃ sur la figure 4 illustrent ainsi les écarts avec la fréquence nominale.

En variante, on peut aussi déterminer un écart d'impédance Δ|Z|. Il s'agit de déterminer pour chaque circuit résonant, l'écart entre le niveau de l'impédance détecté pour une fréquence f_{g} égale à la fréquence de résonance nominale du circuit résonant, avec le niveau nominal de cette impédance, c'est-à-dire celle donnée par la courbe "nominale" de la figure 3.

Cette mesure est illustrée sur la figure 4, sur laquelle sont représentées en trait plein, une courbe relevée, et en pointillé, la courbe nominale. Pour la fréquence de résonance nominale fn₂ : la valeur nominale de l'impédance aux bornes de l'ensemble des circuits résonants, à cette fréquence de résonance nominale fn₂, est z2. On la compare avec la valeur z'2 de l'impédance à cette même fréquence de résonance fn2, sur la courbe relevée. L'écart d'impédance Δz₂ traduit une variation de la position du pic de résonance du circuit résonant correspondant.

Ces écarts de fréquence ou d'impédance peuvent avantageusement fournir des indications de dépassement de seuil, en comparant ces écarts, à des seuils prédéterminés. On peut ainsi déterminer si une cellule est altérée, mais encore viable, ou définitivement dégradée.

Dans une autre mise en oeuvre, qui peut remplacer ou compléter la première, on s'intéresse à l'écartement entre des pics de résonance successifs, c'est-à-dire les différences fdᵢ₊₁ - fdᵢ, qui plutôt que de fournir une indication sur chaque cellule, fournit une indication quantitative sur l'homogénéité relative des cellules entre elles. De manière simplifiée, si l'allure générale de la courbe n'est pas modifiée au cours du temps, comme dans le cas illustré sur la figure 4, cela indique une évolution homogène, qui correspond à une évolution homogène des tensions délivrées par les cellules. Pour améliorer la précision du dispositif, on peut corréler les indications obtenues des courbes avec les informations obtenues d'autres capteurs : par exemple d'un capteur 4 fournissant une mesure de la tension U aux bornes des N cellules de l'empilement et/ou d'un autre capteur 3 mesurant localement la température θ dans le générateur.

En pratique, on cherche alors à détecter si il y a une anomalie de l'écartement entre deux pics de résonance détectés successifs, par rapport à leur écartement dans les conditions nominales. C'est ce qu'illustre la figure 5. La mesure de l'écartement entre deux pics successifs est donnée par la différence entre les fréquences de résonance correspondantes, à comparer à la différence entre les fréquences de résonance nominales. Par exemple sur la figure 5, on voit que l'écartement égal à fd₄-fd₃ entre les 3^{ième} et 4^{ième} pics détectés est différent de l'écartement nominal égal à fn₄-fn₃. La figure 5 montre ainsi une anomalie des écartements entre le 2^{ième} pic et le ₃^{ième} pic, entre le 3^{ième} pic et le 4^{ième} pic, et entre le 4^{ième} pic et le 5^{ième} pic, traduisant une évolution hétérogène des cellules.

Les figures 6 et 7 illustrent une variante d'implémentation du circuit de contrôle selon l'invention, plus simple de mise en oeuvre, les circuits résonants étant réalisés avec des composants identiques, de manière à être tous centrés sur la même fréquence de résonance nominale fn. La courbe de variation d'impédance avec la fréquence signal du générateur 1 a alors la forme de la courbe en trait plein illustrée sur la figure 6, centrée sur la fréquence de résonance nominale fn. Au cours du temps, ou en fonction des conditions opérationnelles, par exemple en fonction de la température ou du courant délivré, l'état des cellules peut évoluer de manière homogène : on obtient une courbe centrée sur une fréquence de résonance différente fd, comme illustré par la courbe en pointillé sur la figure 6, mais d'allure générale identique.

En cas d'un défaut propre à une cellule au moins, la courbe d'impédance va se déformer et faire apparaître au moins un pic secondaire d'impédance centré sur une fréquence de résonance "secondaire" fds, en plus d'un pic central centré sur une fréquence de résonance principale fd. La détection de pic(s) secondaire(s) est une indication d'une évolution hétérogène des cellules de l'empilement. La détection de la déformation sera d'autant plus facile que les circuits résonants auront un coefficient de qualité élevé.

Cette implémentation est plus simple à mettre en oeuvre puisqu'elle utilise des circuits résonants tous identiques. Elle peut être utilisée lorsque l'on cherche seulement à surveiller l'évolution d'ensemble des cellules. Elle pourra être avantageusement couplée à une mesure de la tension aux bornes G₁, G₂ des N cellules de l'empilement et/ou de la température moyenne dans le générateur.

A titre d'illustration réaliste de l'invention, on a effectué une simulation pour un générateur électrochimique de type pile à combustible à membrane électrolyte polymère dite encore à échange de protons, appelés pile PEMFC (pour *proton exchange membrane fuel cells* ou *polymer electrolyte membrane fuel cells*). Pour cette simulation, on a choisi un empilement de 8 cellules PEMFC.

Le circuit de contrôle doit être défini en correspondance avec les caractéristiques électriques de ces cellules, dont la tension aux bornes peut varier de 0,4 volt, qui est la tension limite basse en dessous de laquelle il y a risque d'échauffement ou de destruction d'une cellule, et 1 volt, qui est la tension à vide de la cellule. La diode varicap de référence fabricant BB202, qui est un composant CMS de l'électronique grand public largement utilisé, convient bien à la surveillance de cette gamme de tension. En effet sa capacité varie de manière très significative, de 30 picofarads à 15 picofarads environ, avec la tension de polarisation inverse quand celle-ci passe de 0,3 volt à 1,5 volts, permettant ainsi une détection de précision dans cette plage de fonctionnement. On peut ainsi utiliser cette diode varicap dans chacun des circuits résonants.

On choisit une implémentation du circuit de contrôle utilisant des circuits résonants centrés sur des fréquences de résonance différentes. Il faut donc varier la valeur de l'impédance Lᵢ d'un circuit résonant à l'autre. On a choisi des inductances CMS de référence fabricant ATC 1008 WL, de respectivement 100 nH, 150 nH, 220 nH, 330 nH, 470 nH, 680 nH, 1000 nH, et 1500 nanoHenrys pour réaliser les éléments réactifs L₁, L₂, L₃, L₄, L₅, L₆, L₇, L₈ des huit circuits résonants.

Les composants inductifs proposés ont des facteurs de qualité satisfaisants, typiquement de 60 pour L₁ et 28 pour L₈.

Dans la simulation on a tenu compte des valeurs des résistances de découplage Rp, des capacités de découplage Cd, des impédances de câblage, ainsi que du coefficient de qualité de chacun des éléments inductifs, sous forme d'une résistance de valeur appropriée en parallèle sur chaque circuit résonant.

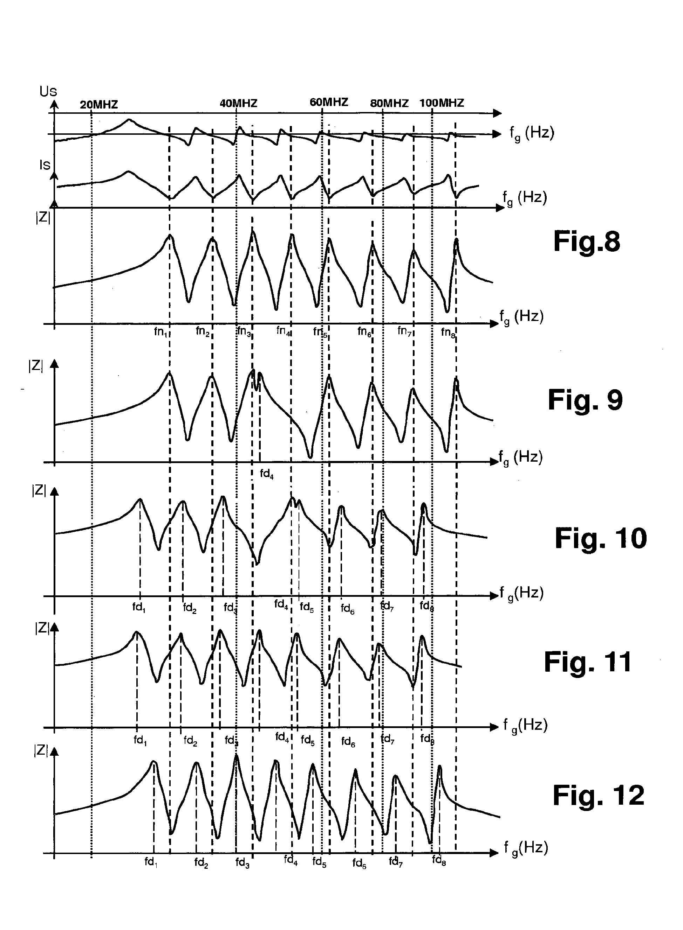

Les figures 8 à 12 illustrent les courbes |Z|=g(f_{g}) obtenues.

La courbe |Z|=g(f) illustrée sur la figure 8 (axe de fréquence en échelle logarithmique) est la courbe nominale, obtenue pour des cellules délivrant chacune une tension nominale de 1 volt, appliquée comme tension de polarisation inverse de la diode varicap de chacun des huit circuits résonants. Elle est en pratique obtenue par la mesure par le circuit de détection 2 de la tension et du courant aux bornes de l'ensemble des circuits résonants, en fonction de la fréquence du signal d'excitation émis par le générateur de fréquence 1.

On obtient huit pics de résonance dont les positions donnent les fréquences de résonance nominale fn₁ à fn₈, respectivement égales dans l'exemple à 28,93 MHz, 35,54 MHz, 43,12 MHz, 51,88 MHz, 61,94 MHz, 75,92 MHz, 92,05 MHz et 112,46 MHz.

Sur la figure 8, on a également représenté les courbes de mesure du courant Is et de la tension Us aux bornes de l'ensemble des circuits résonants, en fonction de la fréquence f_{g}.

Les courbes 9 à 12 sont les courbes de variation d'impédance avec la fréquence d'excitation du générateur de fréquence 1, reflétant la situation du générateur dans différents cas de figure. Elles mettent en évidence soit un comportement homogène des cellules, soit des comportements hétérogènes révélateurs de défauts sur une ou plusieurs cellules, soit une défaillance générale de toutes les cellules.

Plus spécialement la courbe de la figure 9 met en évidence un défaut de la 4ième cellule, le pic de résonance correspondant étant clairement "déplacé" par rapport aux autres. Plus précisément, la position des pics de résonance détectés donnent comme fréquences de résonance fd₁ à fd₈, respectivement 28,93 MHz, 35,51 MHz, 43,05 MHz, 44,7 MHz, 61,94 MHz, 75,92 MHz, 92,05 MHz, 112,46 MHz : ainsi toutes les fréquences de résonance détectées sont égales ou très proches de leur valeur nominale, exceptée fd₄ qui en est bien écartée, de 7,18 MHz. Dans l'exemple de la simulation, cette fréquence fd₄ correspond à une tension de 0,4 volt délivrée par la cellule correspondante. Ainsi, en définissant un seuil de 7 MHz pour cette cellule, on peut détecter un dépassement de seuil correspondant à la tension limite basse de la cellule, en utilisant l'écart entre la fréquence de résonance fd₄ détectée et la fréquence nominale fn₄.

La courbe de la figure 10 montre une autre situation dans laquelle seule la 4^{ième} cellule correspond à un état de fonctionnement nominal avec une fréquence de résonance détectée fd₄ égale à sa fréquence de résonance nominale fn₄, alors que pour les autres cellules, les positions des pics de résonance détectés donnent des fréquences de résonance bien différentes de leurs valeurs nominales, qui correspondent à des conditions de simulation dans lesquelles ces cellules fournissent chacune une tension de 0,4 volts. Dans l'exemple on obtient 24,87 MHz pour fd₁, 30,53 MHz pour fd₂, 37,04 MHz pour fd₃, 53,33 MHz, pour fd₅, 65,26 MHz pour fd₆, 79,07 MHz pour fd₇ et 96,6 MHz pour fd₈. La mesure de l'écart de la fréquence de résonance détectée à sa valeur nominale, et/ou la comparaison de cet écart à un seuil correspondant à la tension limite basse, permet ainsi de déterminer l'état individuel de chaque cellule. Dans l'exemple, on trouverait que la cellule 4 fonctionne de manière nominale alors que toutes les autres sont défectueuses. La mesure de l'écartement entre deux pics détectés successifs et la comparaison à une valeur nominale de cet écartement donnerait une indication de comportement hétérogène des cellules.

La figure 11 correspond à une simulation avec toutes les cellules défectueuses, ne délivrant à leurs bornes qu'une tension de 0,4 volt : la courbe obtenue est globalement homogène mais décalée en fréquence par rapport à la figure 8. On peut comme précédemment déterminer l'état de chacune des cellules en considérant la fréquence de résonance de chaque pic détecté, et/ou le comportement homogène ou non des cellules, en considérant l'écartement entre les pics détectés.

Enfin, la figure 12 illustre une situation intermédiaire de la figure 11, de cellules délivrant chacune une tension homogène de 0,7 volts. La courbe montre une évolution homogène, mais avec des écarts de fréquence moindre, les fréquences de résonance détectées fd₁ à fd₈ étant ici respectivement 26,87 MHz, 33,01 MHz, 40,06 MHz, 48,19 MHz, 57,54 MHz, 70,52 MHz, 85,51 MHz, 104,47 MHz. Les différentes mesures effectuées selon l'invention à partir des positions des pics de résonance détectés montreraient que chaque cellule est moins bonne, et/ou que chaque cellule est moins bonne mais pas complètement défectueuse (pas de franchissement de seuil), et/ou un comportement homogène des cellules.

Comme précédemment indiqué on peut prévoir de coupler les informations obtenues à partir de ces courbes de variation d'impédance, avec d'autres informations, telles que notamment, la tension U aux bornes de l'empilement des N cellules, ou encore la température moyenne θ du générateur.

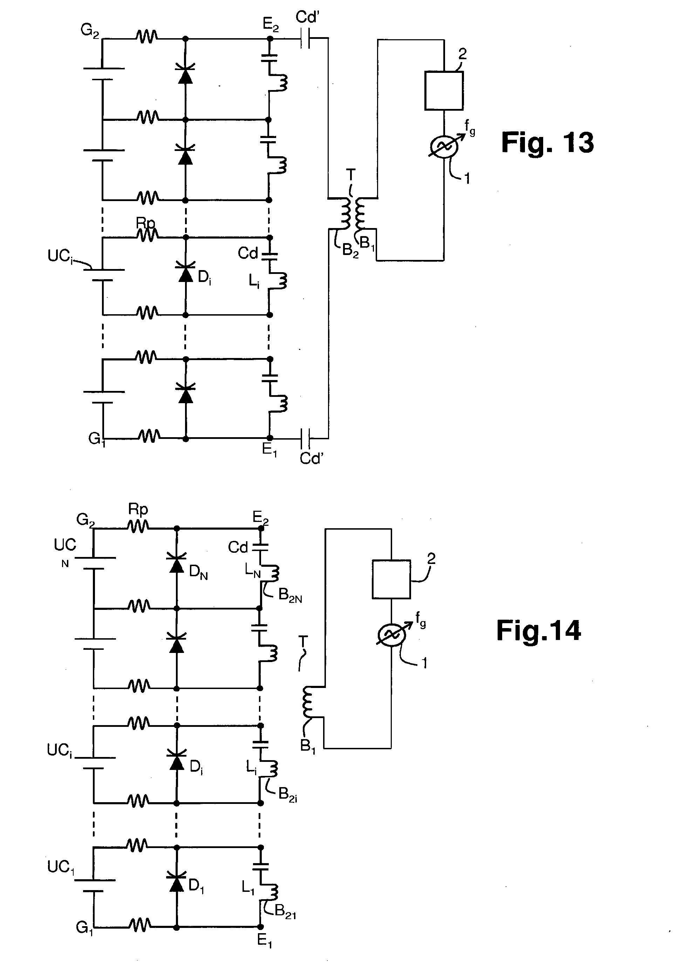

L'invention proposée peut facilement inclure une isolation galvanique. Dans la version illustrée sur la figure 13, un transformateur T est prévu dont un bobinage secondaire B2 alimente les circuits résonants (Lᵢ, Dᵢ). Dans l'exemple illustré, le bobinage secondaire est connecté aux bornes E1, E2 de l'ensemble des circuits résonants, via des capacités de découplage Cd', qui sont nécessaires dans la configuration illustrée dans laquelle des capacités de découplage Cd sont directement connectées en série avec chaque élément inductif. Le bobinage primaire B1 est connecté aux bornes de l'ensemble série du générateur 1 et du circuit de mesure 2.

Dans la description qui vient d'être faite, les éléments placés en parallèle des éléments « varicap » sont des inductances. L'utilisation de circuits résonants remplaçant ces inductances pourrait être avantageusement envisagée, ces circuits résonants pouvant permettre de donner au circuit résonant total, un coefficient de qualité plus élevé. Par exemple l'utilisation d'éléments tels que des quartz à la place des inductances Lᵢ pourrait être envisagée.

D'autres variantes peuvent encore être envisagées. Notamment, les réalisations qui viennent d'être décrites font référence à un mode d'implémentation entièrement filaire.

Des versions partiellement filaires sont envisageables : connexion filaire pour la polarisation des circuits résonants par les cellules, connexion sans contact pour l'excitation et/ou la détection en fréquence. Les figures 14 à 16 en sont des illustrations symboliques.

Dans une variante illustrée sur la figure 14, le bobinage secondaire du transformateur T est réalisé par des bobinages élémentaires B₂ᵢ, réalisés par les antennes inductives Lᵢ des circuits résonants.

On peut envisager une autre variante (non illustrée) dans laquelle le moyen de détection comprend un réseau d'antennes inductives (réalisant un transformateur T) pour recueillir un signal alternatif issu des composants réactifs des circuits résonants, qui est la signature en régime alternatif des circuits résonants, les circuits résonants étant alimentés par le générateur de fréquence par une connexion filaire, c'est-à-dire que le générateur de fréquence 1 est connecté aux bornes E₁ et E₂ de l'ensemble des circuits résonants par des fils. Cette variante permettrait d'améliorer la qualité des mesures effectuées, tout en restant dans une transmission sans contact des informations de tensions élémentaires.

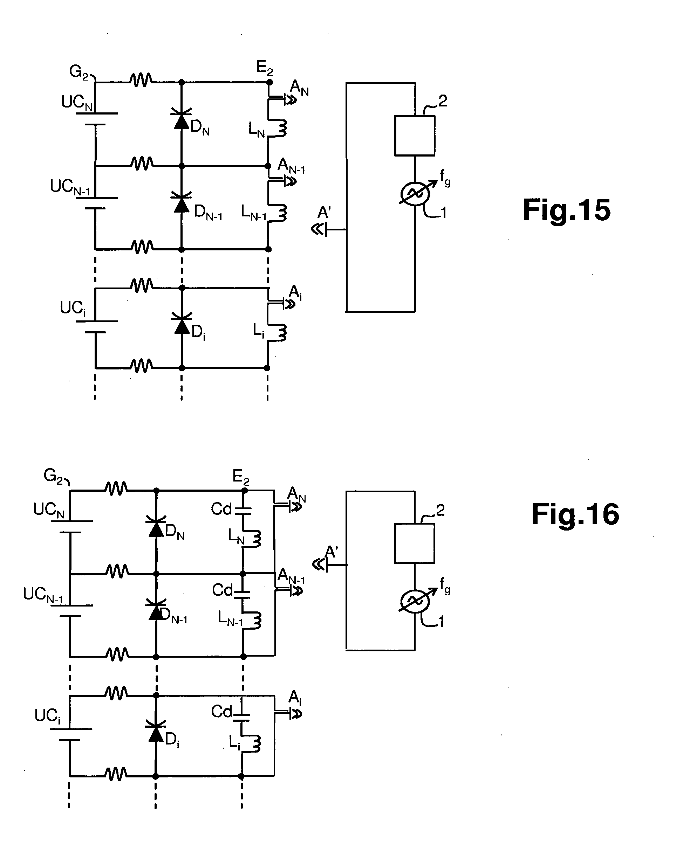

Les figures 15 et 16 illustrent une autre version partiellement filaire, utilisant des antennes électriques radiofréquence. Dans cette version, les circuits résonants comportent chacun une antenne électrique radiofréquence Aᵢ excitée par une antenne électrique A'. Lorsque la fréquence f_{g} correspond à la fréquence de résonance d'un circuit résonant associé à une cellule, l'impédance équivalente vue par l'antenne A' voit un extremum. Cette variante peut utiliser l'antenne du circuit de détection comme symbolisé sur les figures 15 et 16, ou une autre antenne.

Dans la version de la figure 15, chaque antenne radioélectrique émettrice est placée en série avec l'inductance Lᵢ du circuit résonant associé et assure avantageusement également la fonction de capacité de découplage Cd permettant de prendre en charge la composante de tension continue qui autrement serait vue par la seule résistance parasite de l'inductance Lᵢ. Dans la version de la figure 16, l'antenne radioélectrique émettrice est placée en parallèle avec l'inductance Lᵢ. On retrouve alors de préférence au moins une capacité de découplage Cd en série avec l'inductance, comme expliqué en relation avec les figures 1 et 2.

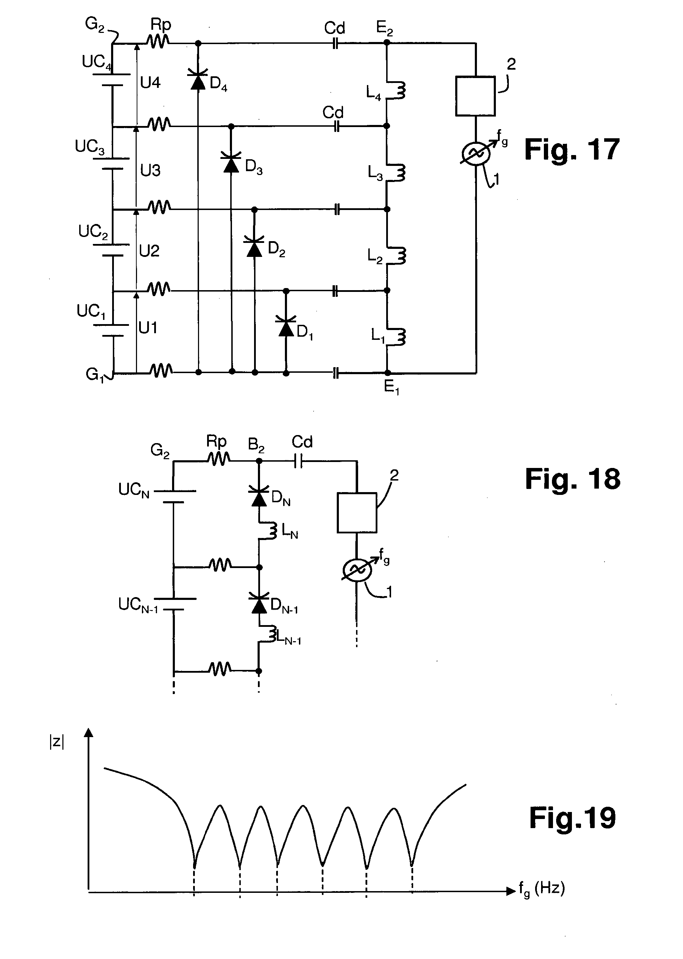

La figure 17 illustre quant à elle une autre variante de réalisation des circuits résonants, suivant une structure imbriquée. Ainsi, dans un empilement de N cellules de rang n=1 à N, la diode varicap Dₙ de rang n est polarisée directement, ou par l'intermédiaire de résistances Rp comme illustré, par la tension aux bornes des n cellules de rang 1 à n. Le circuit résonant de rang n associé à la diode varicap Dₙ comprend l'ensemble série des n inductances L₁ à Lₙ, en parallèle sur la diode varicap Dₙ, chaque inductance étant en série sur une des n cellules.

La diode Dₙ est ainsi polarisée par la tension délivrée aux bornes des n cellules, et le circuit résonant de rang n associé permet de surveiller la tension U1+U2+....Un, aux bornes des n cellules de rang 1 à n. Les diodes varicap étant polarisées par des tensions toutes différentes, chacune devra alors être choisie pour correspondre à une plage de tension différente à surveiller.

Par contre la structure permet d'utiliser N inductances de même valeur.

L'exploitation des positions des pics de résonances détectée pour remonter à l'état de chaque cellule élémentaire, compte-tenu de leur imbrication avec les circuits de résonance sera en pratique plus complexe.

On notera que la figure 17 illustre une implémentation entièrement filaire ainsi que la présence de capacités de découplage série, partagées par des circuits de résonance adjacents. Toutes les variantes décrites, qu'il s'agisse notamment des capacités de découplage ou des versions partiellement filaires peuvent s'appliquer à une structure imbriquée des circuits résonants. Enfin, la structure imbriquée peut imbriquer les diodes varicap comme illustrée. Elle peut aussi imbriquer les inductances, voire les diodes varicap et les inductances.

Les figures 18 et 19 illustrent une autre mise en oeuvre de l'invention, utilisant des circuits résonants de type LC série, plutôt que parallèle. Les pics de résonance correspondront alors à des minimas d'impédance comme illustré sur la figure 19. Les principes d'exploitation des courbes |Z|=g(f_{g}) restent les mêmes que ceux exposés dans le cas de circuits résonants de type LC parallèle.

On notera que certaines applications, notamment des applications de puissance, nécessitent l'utilisation d'un générateur électrochimique comprenant un très grand nombre de cellules, qui peuvent être empilées d'un seul tenant, ou par paquets de N cellules successives. Pour ces générateurs, et compte-tenu de la faible fréquence de mesure nécessaire à la surveillance des cellules, il est alors tout à fait envisageable de réaliser une surveillance par groupe de n cellules, tout en n'utilisant qu'un seul circuit d'excitation/détection au moyen d'une solution multiplexée par laquelle ce circuit d'excitation/détection est connectée successivement en séquence aux bornes des circuits résonants de chaque groupe de cellules.

L'invention qui vient d'être décrite propose ainsi un dispositif de surveillance comprenant un circuit entièrement passif local, associé à chaque cellule d'un empilement, et tous ces circuits sont excités par une seule et même source externe, un générateur de fréquence variable permettant d'effectuer les mesures de tension des cellules par balayage de fréquence continu. Elle permet une intégration au sein du générateur électrochimique et apporte un avantage considérable en terme de connectique puisque seulement deux fils de mesure sont nécessaires par empilement de générateur électrochimique dans une configuration filaire, et permet également une implémentation sans contact.

## Revendications

1. Générateur électrochimique composé d'au moins un empilement de N cellules (UCᵢ) électriquement en série, et pourvu de moyens de contrôle de la tension aux bornes de ces cellules, **caractérisé en ce que** les moyens de contrôle comportent :
- pour chaque cellule (UCᵢ) à contrôler,
- un premier composant passif réactif (Dᵢ) dont l'impédance varie en fonction de la tension continue à ses bornes, ce composant étant polarisé par la tension délivrée par la cellule à contrôler (UCᵢ) ou par un groupe de cellules en série comprenant la cellule à contrôler, et
- au moins un deuxième composant passif réactif (Lᵢ) formant avec le premier composant passif réactif un circuit résonant série ou parallèle ayant une fréquence de résonance nominale prédéterminée (fnᵢ) pour une tension de polarisation nominale délivrée par la cellule ou le groupe de cellules,
- un générateur (1) de signal à fréquence variable (f_{g}) alimentant l'ensemble des N circuits résonants,
- un moyen de détection (2) de la position de pic(s) de résonance de l'ensemble ainsi alimenté, ce moyen fournissant une indication d'un écart entre une fréquence de résonance (fdᵢ) correspondant à un pic détecté et une fréquence de résonance nominale (fnᵢ).

2. Générateur électrochimique selon la revendication 1, dans lequel les circuits résonants sont placés en série, le premier composant passif réactif de chaque circuit résonant étant alimenté directement ou par l'intermédiaire de résistances (Rp) par la tension d'une cellule à contrôler (UCᵢ).

3. Générateur électrochimique selon la revendication 1 ou 2, **caractérisé en ce que** le premier composant passif réactif est une diode varicap et le deuxième une inductance.

4. Générateur électrochimique selon la revendication 1 ou 2, **caractérisé en ce que** le premier composant passif réactif est une diode varicap et le deuxième un circuit ayant les caractéristiques d'un circuit résonant tel qu'un quartz.

5. Générateur électrochimique selon l'une quelconque des revendications précédentes, dans lequel les N circuits résonants ont des fréquences de résonance nominales différentes.

6. Générateur électrochimique selon l'une quelconque des revendications 1 à 4, dans lequel les N circuits résonants ont des fréquences de résonance nominales identiques.

7. Générateur électrochimique selon la revendication 5 ou 6, dans lequel le moyen de détection de la position des pics de résonance fournit une indication d'un écart entre la position d'un pic de résonance détecté et la position dite position nominale correspondant à la fréquence de résonance nominale d'un circuit résonant.

8. Générateur électrochimique selon la revendication 7, dans lequel le moyen de détection fournit une indication d'un dépassement de seuil d'écart entre la position d'un pic de résonance détecté et sa position nominale.

9. Générateur électrochimique selon la revendication 5 ou 6, dans lequel le moyen de détection fournit une indication quantitative de l'homogénéité de l'ensemble des cellules par analyse des décalages relatifs entre pics de résonance.

10. Générateur électrochimique selon la revendication 5 ou 6, dans lequel le moyen de détection de la position des pics de résonance fournit une indication d'un écart entre niveau d'impédance détecté aux bornes (E₁, E₂) de l'ensemble des circuits résonants pour une fréquence (f_{g}) du générateur égale à la fréquence de résonance nominale d'un circuit résonant et un niveau dit niveau nominal de l'impédance pour cette même fréquence et pour la tension nominale fournie par la cellule correspondante.

11. Générateur électrochimique selon la revendication 10, dans lequel le moyen de détection fournit une indication d'un dépassement de seuil d'écart entre le niveau d'impédance détecté et le niveau d'impédance nominal.

12. Générateur électrochimique selon l'une quelconque des revendications 1 à 11, dans lequel les circuits résonants sont excités par le générateur de fréquence par l'intermédiaire d'une connexion filaire aux bornes (E₁, E₂) de l'ensemble de circuits résonants.

13. Générateur électrochimique selon la revendication 12, dans lequel les circuits résonants sont alimentés par le générateur de fréquence par l'intermédiaire d'un transformateur (T) dont un bobinage secondaire (B₂) excite les circuits résonants.

14. Générateur électrochimique selon l'une quelconque des revendications 1 à 11, dans lequel les circuits résonants sont excités par le générateur de fréquence (1) par l'intermédiaire d'un transformateur (T) qui comprend des bobinages secondaires (B₂₁, B_{2N}) formés par les deuxièmes composants réactifs (Lᵢ) des circuits résonants.

15. Générateur électrochimique selon la revendication 12, dans lequel le moyen de détection (2) de la position des pics de résonance comprend un transformateur pour recueillir la signature en régime alternatif des circuits résonants.

16. Générateur électrochimique selon l'une quelconque des revendications 1 à 11, dans lequel le moyen de détection (2) de la position des pics de résonance comprend un ensemble d'antennes inductives pour recueillir la signature en régime alternatif des circuits résonants.

17. Générateur électrochimique selon l'une quelconque des revendications 1 à 11, dans lequel les circuits résonants comprennent chacun une antenne électrique (Aᵢ) placée en série ou en parallèle sur chacune des inductances (Lᵢ) des circuits résonants, qui émet un signal à la fréquence de résonance du circuit résonant correspondant et le moyen de détection comprend une antenne électrique radiofréquence (A') pour recueillir le signal émis par les antennes des circuits résonants.

18. Générateur électrochimique selon la revendication 17, dans lequel les antennes électriques des circuits résonants (Aᵢ) sont en série avec les inductances (Lᵢ) et servent de capacité de découplage pour éliminer une composante de tension continue dans ces inductances.

19. Générateur électrochimique selon l'une quelconque des revendications 1 à 18, dans lequel l'information issue du dispositif est associée à d'autres mesures, telles que une mesure de la tension totale (U) aux bornes du générateur électrochimique ou une mesure locale de température, pour améliorer la précision des mesures ou des seuils de détection.

## Patentansprüche

1. Elektrochemischer Generator, der wenigstens einen Stapel von N Zellen (UCᵢ) umfasst, die elektrisch in Serie geschaltet und mit Mitteln zum Regeln der Spannung an den Anschlüssen der Zellen ausgestattet sind, **dadurch gekennzeichnet, dass** die Steuermittel Folgendes umfassen:
- für jede zu steuernde Zelle (UCᵢ):
- eine erste reaktive passive Komponente (Dᵢ), deren Impedanz in Abhängigkeit von der Gleichspannung an ihren Anschlüssen variiert, wobei die Komponente durch die Spannung polarisiert wird, die von der zu steuernden Zelle (UCᵢ) oder von einer Gruppe von in Serie geschalteten Zellen zugeführt wird, die die zu steuernde Zelle beinhaltet; und
- wenigstens eine zweite reaktive passive Komponente (Lᵢ), die mit der ersten reaktiven passiven Komponente eine serielle oder parallele Resonanzschaltung mit einer vorbestimmten Nennresonanzfrequenz (fnᵢ) für eine von der Zelle oder der Gruppe von Zellen angelegten Nennvorspannung bildet;
- einen Generator (1) für ein Signal mit veränderlicher Frequenz (fg), der den Satz von N Resonanzschaltungen speist;
- ein Mittel (2) zum Erkennen der Position der/von Resonanzspitze(n) des so gespeisten Satzes, wobei dieses Mittel eine Anzeige einer Abweichung zwischen einer Resonanzfrequenz (fdᵢ) entsprechend einer erkannten Spitze und einer Nennresonanzfrequenz (fnᵢ) bereitstellt.

2. Elektrochemischer Generator nach Anspruch 1, wobei die Resonanzschaltungen in Serie geschaltet sind, wobei die erste reaktive passive Komponente jeder Resonanzschaltung direkt oder über Widerstände (Rp) mit der Spannung einer zu steuernden Zelle (UCᵢ) gespeist wird.

3. Elektrochemischer Generator nach Anspruch 1 oder 2, **dadurch gekennzeichnet, dass** die erste reaktive passive Komponente eine Varicap-Diode und die zweite ein Induktor ist.

4. Elektrochemischer Generator nach Anspruch 1 oder 2, **dadurch gekennzeichnet, dass** die erste reaktive passive Komponente eine Varicap-Diode und die zweite eine Schaltung mit den Charakteristiken einer Resonanzschaltung wie eine Quarzschaltung ist.

5. Elektrochemischer Generator nach einem der vorherigen Ansprüche, wobei die N Resonanzschaltungen unterschiedliche Nennresonanzfrequenzen haben.

6. Elektrochemischer Generator nach einem der Ansprüche 1 bis 4, wobei die N Resonanzschaltungen identische Nennresonanzfrequenzen haben.

7. Elektrochemischer Generator nach Anspruch 5 oder 6, wobei das Mittel zum Erkennen der Position von Resonanzspitzen eine Anzeige einer Abweichung zwischen der Position einer erkannten Resonanzspitze und der Position bereitstellt, die als Nennposition bezeichnet wird und die der Nennresonanzfrequenz einer Resonanzschaltung entspricht.

8. Elektrochemischer Generator nach Anspruch 7, wobei das Erkennungsmittel eine Überschreitung eines Schwellenwertes für die Abweichung zwischen der Position einer erkannten Resonanzspitze und ihrer Nennposition anzeigt.

9. Elektrochemischer Generator nach Anspruch 5 oder 6, wobei das Erkennungsmittel eine quantitative Anzeige der Homogenität des Satzes von Zellen durch Analysieren von relativen Verschiebungen zwischen Resonanzspitzen gibt.

10. Elektrochemischer Generator nach Anspruch 5 oder 6, wobei das Mittel zum Erkennen der Position der Resonanzspitzen eine Anzeige einer Abweichung zwischen dem an den Anschlüssen (E₁, E₂) des Satzes von Resonanzschaltungen erkannten Impedanzpegel für eine Frequenz (fg) des Generators, die gleich der Nennresonanzfrequenz einer Resonanzschaltung ist, und einem Pegel, als Nennpegel bezeichnet, der Impedanz für dieselbe Frequenz und für die von der entsprechenden Zelle bereitgestellte Nennspannung gibt.

11. Elektrochemischer Generator nach Anspruch 10, wobei das Erkennungsmittel eine Anzeige für das Überschreiten eines Schwellenwertes für die Abweichung zwischen dem erkannten Impedanzpegel und dem Nennimpedanzpegel gibt.

12. Elektrochemischer Generator nach einem der Ansprüche 1 bis 11, wobei die Resonanzschaltungen vom Frequenzgenerator über eine Drahtverbindung mit den Anschlüssen (E₁, E₂) des Satzes von Resonanzschaltungen erregt werden.

13. Elektrochemischer Generator nach Anspruch 12, wobei die Resonanzschaltungen vom Frequenzgenerator über einen Transformator (T) gespeist werden, dessen Sekundärspule (B₂) die Resonanzschaltungen erregt.

14. Elektrochemischer Generator nach einem der Ansprüche 1 bis 11, wobei die Resonanzschaltungen vom Frequenzgenerator (1) über einen Transformator (T) erregt werden, der Sekundärspulen (B₂₁, B_{2N}) umfasst, die von den zweiten reaktiven Komponenten (Lᵢ) der Resonanzschaltungen gebildet werden.

15. Elektrochemischer Generator nach Anspruch 12, wobei das Mittel (2) zum Erkennen der Position der Resonanzspitzen einen Transformator zum Empfangen der Signatur der Resonanzschaltungen wechselweise umfasst.

16. Elektrochemischer Generator nach einem der Ansprüche 1 bis 11, wobei das Mittel (2) zum Erkennen der Position der Resonanzspitzen einen Satz von induktiven Antennen zum Empfangen der Signatur der Resonanzschaltungen wechselweise umfasst.

17. Elektrochemischer Generator nach einem der Ansprüche 1 bis 11, wobei die Resonanzschaltungen jeweils eine elektrische Antenne (Aᵢ) umfassen, die in Serie oder parallel auf jedem der Induktoren (Lᵢ) der Resonanzschaltungen geschaltet ist, wobei die Antenne ein Signal auf der Resonanzfrequenz der entsprechenden Resonanzschaltung sendet und das Erkennungsmittel eine elektrische Funkfrequenzantenne (A') zum Empfangen des von der Antenne der Resonanzschaltungen gesendeten Signals umfasst.

18. Elektrochemischer Generator nach Anspruch 17, wobei die elektrischen Antennen (Aᵢ) der Resonanzschaltungen in Serie mit den Induktoren (Lᵢ) geschaltet sind und eine Entkopplungskapazität zum Eliminieren einer Gleichspannungskomponente in diesen Induktoren bereitstellen.

19. Elektrochemischer Generator nach einem der Ansprüche 1 bis 18, wobei die von der Vorrichtung kommenden Informationen mit anderen Messungen assoziiert sind, wie z.B. einer Messung der Gesamtspannung (U) an den Anschlüssen des elektrochemischen Generators oder einer lokalen Temperaturmessung, um die Genauigkeit der Messungen oder der Erkennungsschwellenwerte zu verbessern.

## Claims

1. An electrochemical generator comprising at least one stack of N cells (UCᵢ) that are electrically connected in series and provided with means for controlling the voltage at the terminals of said cells, **characterised in that** said control means comprise:
- for each cell (UCᵢ) to be controlled:
- a first reactive passive component (Dᵢ), the impedance of which varies as a function of the direct voltage at its terminals, said component being biased by the voltage delivered by said cell (UCᵢ) to be controlled or by a group of cells connected in series comprising said cell to be controlled; and
- at least one second reactive passive component (Lᵢ) forming, with said first reactive passive component, a series or parallel resonant circuit with a predetermined nominal resonant frequency (fnᵢ) for a nominal bias voltage delivered by said cell or said group of cells;
- a generator (1) of a signal with variable frequency (fg) feeding the set of N resonant circuits;
- a means (2) for detecting the position of one or more resonance peaks of the set thus fed, said means providing an indication of a deviation between a resonant frequency (fdᵢ) corresponding to a detected peak and a nominal resonant frequency (fnᵢ).

2. The electrochemical generator according to claim 1, wherein said resonant circuits are connected in series, said first reactive passive component of each resonant circuit being fed directly or via resistors (Rp) by the voltage of a cell (UCᵢ) to be controlled.

3. The electrochemical generator according to claim 1 or 2, **characterised in that** said first reactive passive component is a varicap diode and said second reactive passive component is an inductor.

4. The electrochemical generator according to claim 1 or 2, **characterised in that** said first reactive passive component is a varicap diode and said second reactive passive component is a circuit with the characteristics of a resonant circuit such as a quartz circuit.

5. The electrochemical generator according to any one of the preceding claims, wherein said N resonant circuits have different nominal resonant frequencies.

6. The electrochemical generator according to any one of claims 1 to 4, wherein said N resonant circuits have identical nominal resonant frequencies.

7. The electrochemical generator according to claim 5 or 6, wherein said means for detecting the position of resonance peaks provides an indication of a deviation between the position of a detected resonance peak and the position, referred to as nominal position, that corresponds to the nominal resonant frequency of a resonant circuit.

8. The electrochemical generator according to claim 7, wherein said detection means provides an indication that a threshold has been exceeded for the deviation between the position of a detected resonance peak and its nominal position.

9. The electrochemical generator according to claim 5 or 6, wherein said detection means provides a quantitative indication of the homogeneity of the set of cells by analysing relative shifts between resonance peaks.

10. The electrochemical generator according to claim 5 or 6, wherein said means for detecting the position of the resonance peaks provides an indication of a deviation between the impedance level detected at the terminals (E₁, E₂) of the set of resonant circuits for a frequency (fg) of said generator that is equal to the nominal resonant frequency of a resonant circuit and a level, referred to as nominal level, of the impedance for said same frequency and for the nominal voltage provided by the corresponding cell.

11. The electrochemical generator according to claim 10, wherein said detection means provides an indication that a threshold has been exceeded for the deviation between the detected impedance level and the nominal impedance level.

12. The electrochemical generator according to any one of claims 1 to 11, wherein the resonant circuits are excited by the frequency generator via a wired connection to said terminals (E₁, E₂) of the set of resonant circuits.

13. The electrochemical generator according to claim 12, wherein said resonant circuits are fed by said frequency generator via a transformer (T), a secondary coil (B₂) of which excites said resonant circuits.

14. The electrochemical generator according to any one of claims 1 to 11, wherein said resonant circuits are excited by said frequency generator (1) via a transformer (T) comprising secondary coils (B₂₁, B_{2N}) formed by said second reactive components (Lᵢ) of said resonant circuits.

15. The electrochemical generator according to claim 12, wherein said means (2) for detecting the position of the resonance peaks comprise a transformer for receiving the signature of said resonant circuits in an alternative state.

16. The electrochemical generator according to any one of claims 1 to 11, wherein said means (2) for detecting the position of the resonance peaks comprise a set of inductive antennae for receiving the signature of said resonant circuits in an alternative state.

17. The electrochemical generator according to any one of claims 1 to 11, wherein said resonant circuits each comprise an electrical antenna (Aᵢ) connected in series or in parallel on each of said inductors (Lᵢ) of said resonant circuits, which antenna transmits a signal at the resonant frequency of the corresponding resonant circuit, and said detection means comprise an electrical radiofrequency antenna (A') for receiving the signal transmitted by the antennae of said resonant circuits.

18. The electrochemical generator according to claim 17, wherein said electrical antennae (Aᵢ) of said resonant circuits are connected in series with said inductors (Lᵢ) and provide a decoupling capacity for eliminating a direct voltage component in said inductors.

19. The electrochemical generator according to any one of claims 1 to 18, wherein the information coming from said device is associated with other measurements, such as a measurement of the total voltage (U) on the terminals of said electrochemical generator or a local temperature measurement, in order to improve the accuracy of the measurements or of the detection thresholds.
